# EUROPÄISCHE PATENTSCHRIFT

(11) **EP 1 741 325 B1**
(45) Veröffentlichungstag und Bekanntmachung des Hinweises auf die Patenterteilung: **12.12.2007**
(21) Anmeldenummer: 05739507.1
(22) Anmeldetag: 08.04.2005
(51) Int. Cl.: H05K 7/20

(54) **KÜHLUNGSMONTAGEPLATTE MIT BEFESTIGUNGSEINRICHTUNG FÜR ELEKTRONISCHE BAUTEILE**
COOLING AND MOUNTING PLATE WITH FIXATION MEANS FOR ELECTRONIC COMPONENTS
PLAQUE DE MONTAGE REFROIDISSANTE AVEC ÉLÉMENTS DE FIXATION POUR COMPOSANTS ELECTRONIQUES

(30) Priorität: 19.04.2004 DE 102004019382; 19.04.2004 DE 202004017950 U; 18.11.2004 DE 102004055815
(43) Veröffentlichungstag der Anmeldung: 10.01.2007
(73) Patentinhaber: Rittal GmbH & Co. KG, 35745 Herborn (DE)
(72) Erfinder: LANG, Martin, 35759 Driedorf (DE); REUTER, Wolfgang, 56479 Liebenscheid (DE); BESSERER, Horst, 35745 Herborn (DE); SAVASCI, Ahmet, 35576 Wetzlar (DE)
(74) Vertreter: Fleck, Hermann-Joseph
(86) Internationale Anmeldenummer: PCT/EP2005/003694
(87) Internationale Veröffentlichungsnummer: WO 2005/101939

(56) Entgegenhaltungen:
- EP-A- 0 271 632
- DE-A1- 3 242 211
- FR-A- 2 664 440
- US-A- 5 263 538
- US-A- 5 546 274
- US-A- 5 943 207
- PATENT ABSTRACTS OF JAPAN Bd. 1996, Nr. 06, 28. Juni 1996 (1996-06-28) -& JP 08 046381 A (MIYACHI TECHNOS CORP), 16. Februar 1996 (1996-02-16)

## Beschreibung

Die Erfindung bezieht sich auf eine Montageplatte für elektronische Bauteile, mit in einem Plattenkörper integrierten Kühlleitungen zur Durchströmung mit einem Kühlmedium, wobei am Plattenkörper eine Befestigungseinrichtung für die Montage der elektronischen Bauteile angeordnet ist, wobei die Befestigungseinrichtung ein ein Befestigungsgewinde aufweisendes Haltestück und zumindest eine hinterschnitten ausgebildete, sich in Erstreckungsrichtung der Montageplatte geradlinig erstreckende erste Nut aufweist, in die das mindestens eine als Nuteinsatz ausgebildete Haltestück zum Festlegen des Bauteils mit einem Fußabschnitt einführbar ist.

Eine derartige Montageplatte ist in der JP 08 046381 A angegeben. Diese bekannte Montageplatte für elektronische Bauteile ist mit Kühlleitungen versehen, die mit separaten, Rippen aufweisenden Kühlkörpern an der Kühlplatte festgelegt sind. Zum Montieren der elektronischen Baueinheiten sind auf der von den Kühlrippen abliegenden flachen Seite hinterschnittene Nuten eingebracht, in die Befestigungsschrauben mit verbreiterten Fußteilen einschiebbar sind, welche mit Schraubbolzen aus den Nutöffnungen vorstehen, um die Bauteile daran festzulegen.

Es ist aus dem Stand der Technik auch bekannt, in einer Montageplatte bzw. -platine aus Aluminium Kühlschlangen einzusetzen, um auf der Montageplatte zu montierende elektronische Geräte, z. B. Frequenzumformer, zu kühlen. Mit einer so genannten "Coldplate" kann die Verlustwärme der elektronischen Bauteile abgeführt werden.

Die elektronischen Bauteile können auf einer derartigen bekannten Montageplatte mittels Schraubverbindungen gehalten werden. Dazu sind an den Gehäusen der elektronischen Bauteile Schraublöcher vorgesehen, durch die hindurch eine Schraube in in der Montageplatte anzubringende Gewindelöcher eingeschraubt werden können. Die bekannten Montageplatten können jedoch wegen der Kühlschlangen nicht ohne Gefahr der Beschädigung verbohrt werden. Zudem weisen die elektronischen Bauteile oftmals unterschiedliche Abmessungen auf, so dass auch unterschiedliche Befestigungsmaße vorgegeben sind. Es ist vielfach also nicht möglich, die Montageplatte mit einem vorgefertigten Raster von Gewindelöchern zu versehen, da die an den Gehäusen der elektronischen Bauteile angebrachten Gewindelöcher mit diesen nicht fluchten.

Bei bekannten Montageplatten der Firma PADA Engineering werden die Kühlschlangen sichtbar an der Plattenoberfläche verlegt, um somit bei einer nachträglichen mechanischen Bearbeitung der Montageplatte versehentliche Beschädigungen der Kühlmittelleitungen weitgehend zu vermeiden.

Allerdings ist es bei den bekannten Montageplatten notwendig, je nach Befestigungsmaß des zu montierenden elektronischen Bauteils speziell angeordnete Gewindelöcher einzubringen. Dies ist fertigungstechnisch aufwändig.

Durch die aufgrund der Lage der Kühlschlangen vorgegebenen Montagebereiche auf der Montageplatte wird auch die Packungsdichte mehrerer zu montierender elektronischer Bauteile reduziert, da aufgrund der Führung der Kühlmittelleitungen nicht jede Position für das Einbringen eines Gewindeloches geeignet ist.

Es ist Aufgabe der Erfindung, eine Montageplatte für elektronische Bauteile anzugeben, die bei reduziertem Montageaufwand und sicherem Halt für zu montierende elektronische Bauteile variable Anordnungsmöglichkeiten auf der Plattenfläche bietet, ohne diese zu verbohren.

Diese Aufgabe wird durch die Merkmale des Anspruches 1 gelöst. Vorteilhafte Weiterbildungen sind jeweils in den Unteransprüchen beschrieben.

Demgemäß weist die Befestigungseinrichtung mindestens ein ein Befestigungsgewinde aufweisendes Haltestück und zumindest eine hinterschnitten ausgebildete, sich in Erstreckungsrichtung der Montageplatte geradlinig erstreckende erste Nut auf, in die das mindestens eine Haltestück zum Festlegen des Bauteils eingeführt werden kann. Durch diese Anordnung wird das zusätzliche Einbringen von Gewindelöchern vermieden. Die Montage ist einfach durchzuführen, wobei aufgrund der beliebigen Positionierung der Haltestücke in der Nut eine Anpassung an die baulichen Vorgaben der Bauteile möglich ist. Gute Anordnungs- und Befestigungsmöglichkeiten ergeben sich dabei dadurch, dass mindestens ein Haltestück als Nuteinsatz ausgebildet ist, der einen in eine der Nuten einschiebbaren Fußabschnitt und einen aus der Nut vorstehenden Kopfabschnitt aufweist, dass der Kopfabschnitt einen im eingesetzten Zustand des Nuteinsatzes von der Montageebene der Montageplatte beabstandeten Befestigungsabschnitt aufweist, der über einem darüber anzuordnenden Fußteil des festzulegenden Bauteils positionierbar ist, wobei der Abstand des Befestigungsabschnittes größer ist als die Stärke des Fußteils in Normalenrichtung zu der Montageebene, und dass in dem Befestigungsabschnitt mindestens eine Gewindebohrung vorhanden ist, in die zum Festlegen des Bauteils eine mit dem Fußteil zusammenwirkende Klemmschraube eindrehbar ist.

Gemäß einem weiteren Grundgedanken kann die Befestigungseinrichtung zumindest eine gleichartig zur ersten Nut oder Rippe ausgebildete und sich parallel zur ersten Nut oder Rippe erstreckende zweite Nut oder Rippe aufweisen, deren Abstand zur ersten Nut oder Rippe im Wesentlichen durch die senkrecht zur ersten und zweiten Nut oder Rippe verlaufende Erstreckungslänge des zu montierenden elektronischen Bauteils bestimmt ist. Dadurch wird sichergestellt, dass bei einem vorgegebenen Befestigungsmaß von zu montierenden elektronischen Bauteilen eine einfache Sicherung an der Montageplatte erfolgen kann.

Gemäß einer vorteilhaften Weiterbildung kann die Befestigungseinrichtung zumindest eine gleichartig zur ersten Nut oder Rippe und zur zweiten Nut oder Rippe ausgebildete und sich parallel zur zweiten Nut oder Rippe erstreckende weitere Nut oder Rippe aufweisen, die sich an der von dem zu montierenden elektronischen Bauteil abgewandten Seite der zweiten Nut oder Rippe in einem Abstand zu dieser erstreckt, der kleiner als der Abstand zwischen der ersten Nut oder Rippe und der zweiten Nut oder Rippe ist. Mit dieser Anordnung wird einem zusätzlich verwendeten weiteren Befestigungsmaß von zu montierenden elektronischen Bauteilen Rechnung getragen.

Auf einfache Weise lassen sich elektronische Bauteile montieren, die Löcher zum Befestigen mit Schrauben aufweisen. Dabei können die elektronischen Bauteile durch Schrauben direkt an den in die Nuten oder Rippen eingeführten Haltestücken befestigt werden oder mittels leistenartiger Halteelemente festgelegt werden, die mittelbar oder unmittelbar an den Haltestücken angebracht sind.

Falls jedoch die Befestigungsmaße der zu montierenden elektronischen Bauteile nicht mit den Abständen zwischen den parallel verlaufenden Nuten übereinstimmen, d.h. die zu montierenden elektronischen Bauteile Löcher aufweisen, deren Abstand zueinander kleiner als der Abstand der zweiten Nut von der ersten Nut oder kleiner als der Abstand der noch weiteren Nut von der ersten Nut ist, kann das Bauteil zumindest einseitig durch ein Winkelblech festgelegt werden, bei dem zumindest eine in das Winkelblech eingreifende Schraube in das in die entsprechende Nut eingeführte Haltestück eingeschraubt wird.

Dabei kann das Winkel blech eine ebene Grundplatte zur Anlage an der Montageplatte und einen dazu abgewinkelten Klemmbereich zur klemmenden Festlegung des zu montierenden elektronischen Bauteils aufweisen. Der Klemmbereich kann dabei an einem am elektronischen Bauteil vorgesehenen Vorsprung klemmend angreifen.

Um eine besonders einfache Anpassung an unterschiedliche Befestigungsmaße von zu montierenden elektronischen Bauteilen zu erreichen, kann das Winkelblech zumindest ein sich senkrecht zur Erstreckungsrichtung der zweiten Nut oder noch weiteren Nut verlaufendes Langloch zur Aufnahme der Schraube aufweisen.

Das Haltestück kann in vorteilhafter Ausbildung eine Federmutter sein.

Fertigungstechnisch ist von Vorteil, wenn die erste Nut, die zweite Nut und/oder die noch weitere Nut mit dem Plattenkörper einstückig ausgebildet sind.

Zu einer einfachen, sicheren Montage tragen des Weiteren die Maßnahmen bei, dass mindestens ein Haltestück als Nutstein mit einem in eine der Nuten einschiebbaren Fußabschnitt und einem aus der Nut vorstehenden Kopfabschnitt ausgebildet ist und dass in dem Kopfabschnitt in Normalenrichtung zur Montageebene eine Gewindebohrung angeordnet ist, an der ein Haltemittel für das Bauteil festschraubbar ist.

Variable Befestigungsmöglichkeiten werden dadurch begünstigt, dass die Befestigungseinrichtung mindestens eine Halteleiste aufweist, die quer zu den Nuten anordenbar und so bemessen ist, dass sie den Abstand zwischen zwei Nuten überspannt und mit ihren beiderseitigen Endabschnitten an in die betreffenden Nuten eingeschobenen Nutsteinen und/oder Nuteinsätzen mittels Gewindebohrungen festlegbar ist.

Eine gewünschte Anordnung an praktisch beliebiger Stelle der Montageebene ohne zusätzliche Bohrungen wird dadurch ermöglicht, dass mindestens eine leistenartige

Brücke vorgesehen ist, die zwischen zwei beidseitig eines Bauteils parallel zueinander angeordneten Halteleisten verschiebbar mit Abstand zu der Montageebene einbringbar ist und Bohrungen aufweist, über die das Bauteil an seinem Fuß mittels mindestens einer Klemmschraube festlegbar ist.

Zu einer einfachen Montage tragen dabei die Maßnahmen bei, dass die Brücke an ihren beiden Endabschnitten zu den Halteleisten hin offene Schlitze aufweist, mit denen sie an den Halteleisten verschiebbar gehalten ist.

Die Anordnungs- und Befestigungsmöglichkeiten werden dadurch erweitert, dass die mindestens eine Halteleiste und/oder Brücke mit einer Reihe von Gewindebohrungen oder Befestigungsdurchbrüchen versehen ist.

Die Stabilität der Befestigungseinrichtung wird dadurch unterstützt, dass die Halteleiste und/oder die Brücke im Querschnitt winkelförmig ausgebildet oder mit mindestens einer Verstärkungsrippe versehen ist.

Nachfolgend wird die Erfindung anhand von bevorzugten Ausführungsformen unter Bezugnahme auf die Zeichnungen näher erläutert. Es zeigen:
- Fig. 1: in schematischer und perspektivischer Seitenansicht eine Montageplatte ohne darauf montierte, zu kühlende elektronische Bauteile,
- Fig. 2: in schematischer und perspektivischer Seitenansicht ein Winkelblech für die an unterschiedliche Befestigungsmaße von zu montierenden elektronischen Bauteilen anpassbare Montage,
- Fig. 3: in schematischer und perspektivischer Seitenansicht die Montageplatte gemäß der Fig. 1 mit darauf montierten, zu kühlenden Freqenzumformern, die jeweils mit einem Winkelblech gemäß der Fig. 2 einseitig klemmend gehalten sind,
- Fig. 4: in den Teilbildern a) bis d) verschiedene Elemente einer Befestigungseinrichtung,
- Fig. 5: eine Montageanordnung in schematischer Ansicht in Draufsicht mit einer Montageplatte, einem zu befestigenden Bauteil und den Elementen der Befestigungseinrichtung nach Fig. 4,
- Fig.6: eine perspektivische Ansicht der Anordnung nach Fig. 5 von einer Seite und
- Fig. 7: eine perspektivische Ansicht der Anordnung nach Fig. 5 von einer gegenüberliegenden Seite bezüglich Fig. 6.

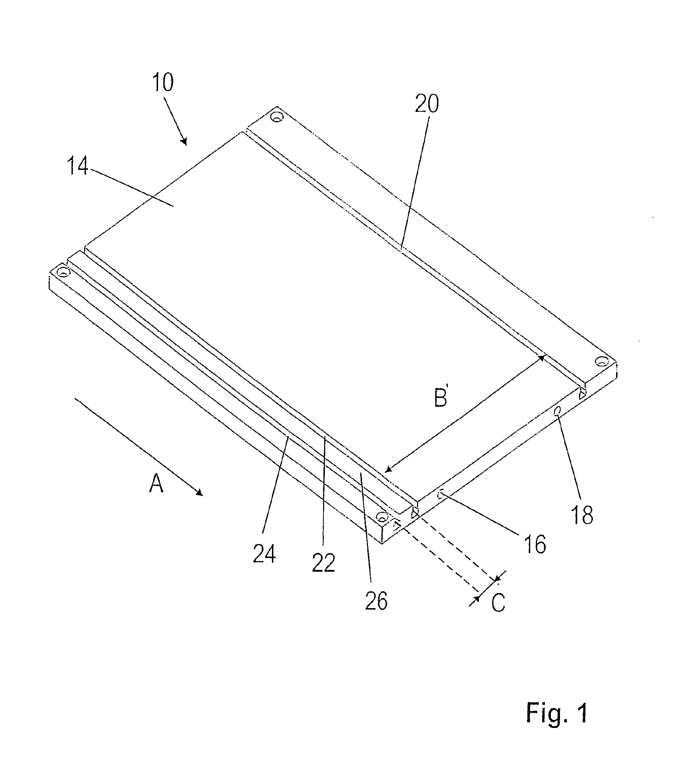

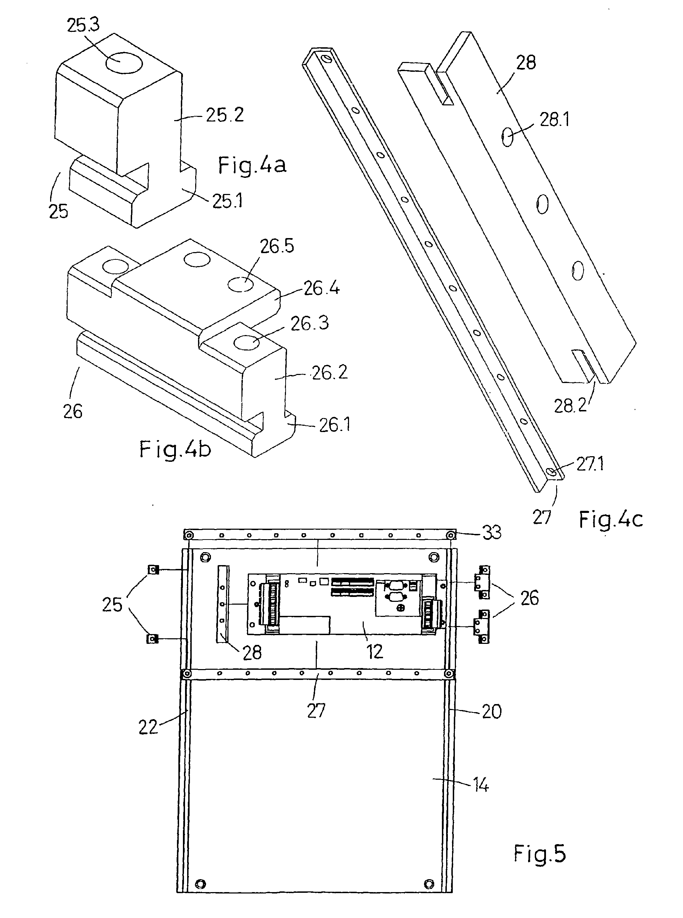

Fig. 1 zeigt in schematischer und perspektivischer Seitenansicht eine Montageplatte 10 ohne darauf montierte, zu kühlende elektronische Bauteile. Die Montageplatte 10 weist einen ebenen Plattenkörper 14 beispielsweise aus Aluminium auf, in dem eine Kühlleitung mit Anschlüssen 16 und 18 in Form einer nicht erkennbaren Kühlschlange zur Durchströmung mit einer Kühlflüssigkeit ausgebildet ist. Der Bereich, in dem die Kühlmittelschlange integral verlegt ist, ist der Plattenkörper 14 nicht zusätzlich bearbeitet sondern flach und eben ausgebildet. An der in Fig. 1 rechten Seite des Bereiches, in dem die Kühlmittelschlange integral verlegt ist, ist eine im Querschnitt etwa C-förmig ausgebildete, sich in Erstreckungsrichtung (Pfeil A) der Montageplatte 10 geradlinig erstreckende hinterschnittene erste Nut 20 einstückig mit dem Plattenkörper ausgebildet. In die erste Nut 20 lässt sich zumindest ein Haltestück, z.B. eine (nicht gezeigte) Federmutter, ein Nutstein 25 (Fig. 4a) und/oder ein Nuteinsatz 26 (Fig. 4b) zur Ausbildung einer Schraubverbindung mit einem elektronischen Bauteil 12 oder weiteren Elementen einer Befestigungseinrichtung vorzugsweise verdrehsicher einführen. Die aufzubauenden elektronischen Bauteile können dann sicher an geeigneter Position fixiert werden.

Zur ersten Nut 20 erstreckt sich parallel eine hinterschnittene zweite Nut 22 an der in Fig. 1 linken Seite des Bereiches des Plattenkörpers, in dem die Kühlmittelschlange integral verlegt ist. Der Abstand zwischen der ersten Nut 20 und der zweiten Nut wird zum einen durch den Bereich des Plattenkörpers, in dem die Kühlmittelschlange integral verlegt ist, und zum anderen durch die senkrecht zur ersten Nut 20 und zur zweiten Nut 22 verlaufende Erstreckungslänge eines zu montierenden elektronischen Bauteils bestimmt.

Zur ersten Nut 20 und zur zweiten Nut 22 verläuft parallel eine hinterschnittene weitere Nut 24, die sich an der von dem zu montierenden Bauteil abgewandten Seite 26 der zweiten Nut in einem Abstand C zu dieser erstreckt. Der Abstand C ist kleiner als der Abstand B zwischen der ersten Nut 20 und der zweiten Nut 22 und ist an ein weiteres Befestigungsmaß als im Fall der zweiten Nut 22 angepasst.

Zum Verständnis der Erfindung wird als Beispiel des Standes der Technik genannt, daß zu montierende elektronische Bauteile, deren Einfassung oder Gehäuse Schraublöcher aufweisen, deren Abstand zueinander dem Abstand B der zweiten Nut 22 von der ersten Nut 20 oder der noch weiteren Nut 24 von der ersten Nut 20 entspricht, können direkt durch Schrauben an den in die Nuten 20, 22, 24 eingeführten Schraubenmuttern befestigt werden.

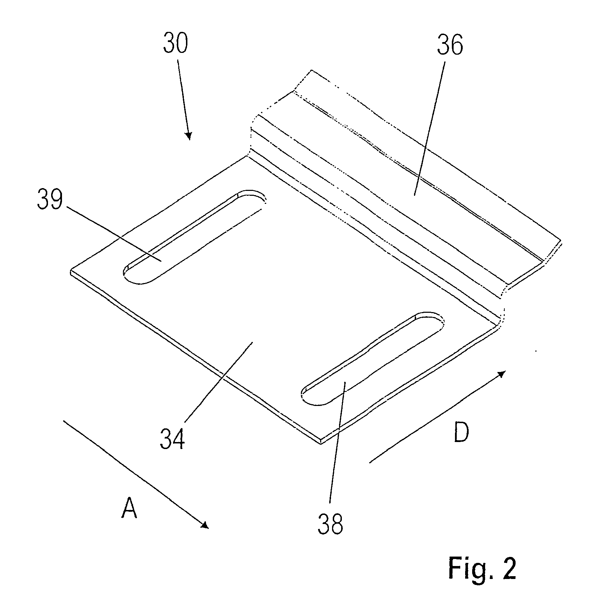

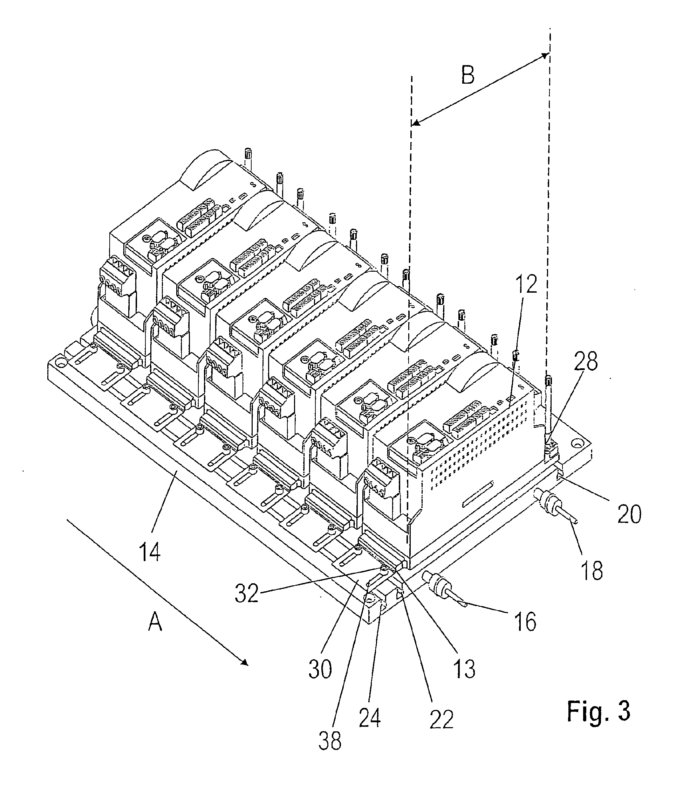

Weiterhin, werden als Standes des Technik Figuren 2 und 3 beschrieben.

Fig. 2 zeigt in schematischer und perspektivischer Seitenansicht ein Winkelblech 30 für die an unterschiedliche Befestigungsmaße von zu montierenden elektronischen Bauteilen anpassbare Montage.

Zu montierende elektronische Bauteile, deren Gehäuse Schraublöcher aufweisen, deren Abstand zueinander kleiner als der (in Fig. 1 gezeigte) Abstand B der zweiten Nut 22 von der ersten Nut 20 oder kleiner als der Abstand der noch weiteren Nut 24 von der ersten Nut 20 ist, können zumindest einseitig durch das Winkelblech 30 mittels zumindest einer in diese eingreifende (nicht gezeigte) Schraube an der in die entsprechende Nut 22 eingeführten Schraubenmutter klemmend festgelegt werden.

Das Winkelblech 30 weist eine ebene Grundplatte 34 zur Anlage an der Montageplatte 10 und einen dazu abgewinkelten, einstückig ausgebildeten Klemmbereich 36 zur klemmenden Festlegung des zu montierenden elektronischen Bauteils auf.

Das Winkelblech 30 weist zwei sich senkrecht (Pfeil D) zur Erstreckungsrichtung (Pfeil A) der zweiten Nut 22 oder noch weiteren Nut 24 verlaufende Langlöcher 38 und 39 zur Aufnahme einer (nicht gezeigten) Schraube auf.

Fig. 3 zeigt in schematischer und perspektivischer Seitenansicht die Montageplatte 10 gemäß der Fig. 1 mit darauf montierten, zu kühlende Frequenzumformern 12, die jeweils mit einem Winkelblech 30 gemäß der Fig. 2 einseitig klemmend gehalten sind.

Die Frequenzumformer, deren Erstreckung B nicht mit den Abständen zwischen den beiden Nuten 20 und 22 übereinstimmt, sind an der in Fig. 3 rechten Seite jeweils mit Schrauben, die in die Nut 20 eingeführte (nicht gezeigte) Federmuttern eingreifen, verschraubt. In Fig. 3 ist eine derartige Schraube mit dem Bezugszeichen 28 versehen.

An der in Fig. 3 linken Seite sind die Frequenzumsetzer 12 jeweils mit einem zusätzlichen Winkelblech, von denen eines mit dem Bezugszeichen 30 dargestellt ist, verklemmt. Beispielsweise in das Langloch 38 des dargestellten Winkelblechs 30 greift eine Schraube 32 in eine in die zweite Nut 22 eingeführte (nicht gezeigte) Federmutter ein. Das Winkelblech 30 greift an einem Vorsprung 13 am Gehäuse des Frequenzumformers 12 klemmend an. Durch die Langlochbefestigung wird das zu den Nutabständen nicht passende Befestigungsmaß ausgeglichen.

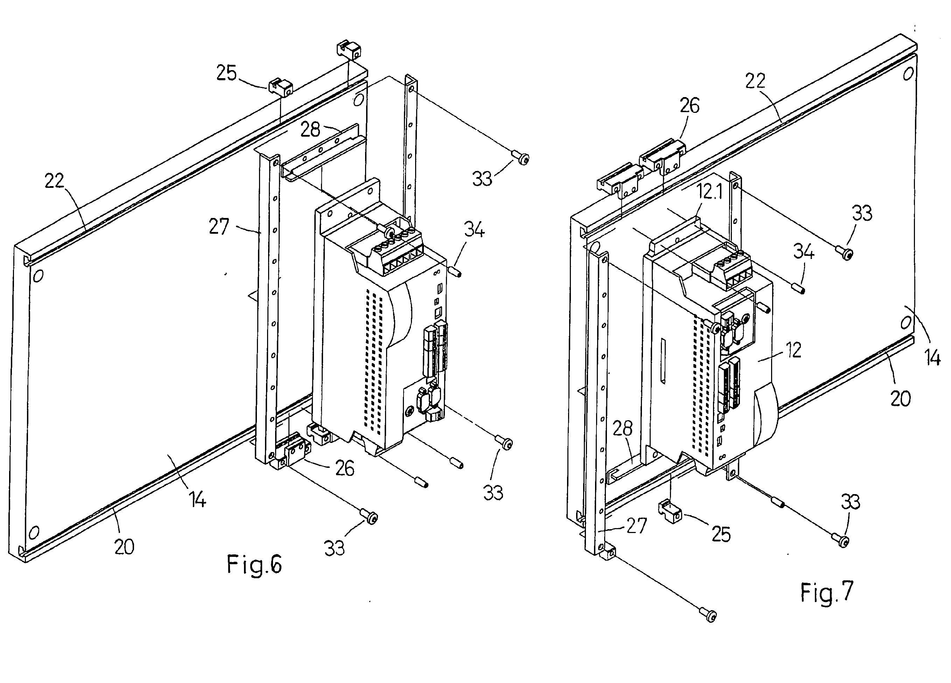

Fig. 4 zeigt in den Teilbildern a) bis d) verschiedene Elemente einer Befestigungseinrichtung, nämlich einen Nutstein 25 (Teilbild a)), einen Nuteinsatz 26 (Teilbild b)), eine Halteleiste 27 (Teilbild c)) und eine leistenartige Brücke 28 (Teilbild d)), die zum Bilden eines Bausatzes in mehr oder weniger großer Anzahl vorhanden sein können, so dass auf der Montageebene der Montageplatte 10 Bauteile unterschiedlicher Abmessungen und/oder an unterschiedlicher Position festgelegt werden können. Das Montageprinzip geht dabei aus den Fig. 5, 6 und 7 hervor. Befestigungsbohrungen in der Montageplatte sind nicht erforderlich.

Wie aus Fig. 4a) ersichtlich, besitzt der Nutstein 25 zum Einschieben in eine im Querschnitt T-förmige Nut 20, 22, 24 einen an den Nutquerschnitt angepassten T-förmigen Fußabschnitt 25.1 sowie einen aus der Nut über die Montageebene vortretenden Kopfabschnitt 25.2, in dessen Oberseite in Normalenrichtung der Montageebene eine Gewindebohrung 25.3 eingebracht ist. Möglich sind auch noch seitliche Gewindebohrungen parallel zur Montageebene. Der Nutstein 25 ist mit dem Fußabschnitt 25.1 verschieblich in der Nut gelagert.

Auch der Nuteinsatz 26 besitzt in Fig. 4b) in entsprechender Weise wie der Nutstein 25 einen im Querschnitt T-förmigen, an den Nutquerschnitt angepassten Fußabschnitt 26.1 sowie einen aus der Nut hervortretenden Kopfabschnitt 26.2, ist jedoch in Nutrichtung länger ausgebildet als der Nutstein 25 und zusätzlich mit einem quer zur Nutrichtung vorstehenden, im eingesetzten Zustand von der Montageebene beabstandeten Befestigungsabschnitt 26.4 versehen. In seinen beiden Endabschnitten sowie in dem Befestigungsabschnitt 26.4 sind in Normalenrichtung von der Oberseite her Gewindebohrungen 26.3 bzw. 26.5 eingebracht.

Wie Fig. 4c) zeigt, ist die Halteleiste 27 im Querschnitt winkelförmig ausgebildet und besitzt in ihrem einen Schenkel eine Reihe von Bohrungen 27.1, die zumindest teilweise auch als Gewindebohrungen ausgebildet sein können. Die in Fig. 4d) gezeigte Brücke 28 ist ebenfalls im Querschnitt winkelförmig ausgebildet und besitzt ebenfalls in einem Schenkel mehrere Bohrungen, die als Gewindebohrung ausgeführt sein können. Außerdem sind in dem die Bohrungen 28.1 nicht tragenden Schenkel beidseitig zu den Enden hin offene Schlitze 28.2 parallel zur Längserstreckung eingebracht.

Wie die Fig. 5, 6 und 7 zeigen, sind die Winkelleisten 27 etwas länger als der Abstand zwischen den beiden in der Nähe der beiden Längsränder verlaufenden Nuten 20, 22 und können wahlweise an entsprechende Position in die Nuten 20, 22 eingeschobenen Nutsteinen 25 oder Nuteinsätzen 26 durch Einführen von Schrauben 33 durch betreffende Bohrungen 27.1 der Halteleiste 27 und Festschrauben in Gewindebohrungen 25.3 bzw. 26.3 festgelegt werden, wobei die Seite der Halteleiste 27 mit den Bohrungen 27.1 vorzugsweise die Oberseite bildet. Auf diese Weise können die Halteleisten 27 in Längsrichtung der Montageplatte 10 bzw. Montageebene verschoben werden, um das Bauteil 12 in gewünschter Längsposition auf der Montageebene anzuordnen. Ein Fußteil 12.1 des Bauteils 12 kann dabei mit dem zugekehrten Befestigungsabschnitt 26.4 eines Nuteinsatzes 26 festgelegt werden, indem durch die Gewindebohrung 26.5 in dem Befestigungsabschnitt 26.4 eine Klemmschraube eingedreht wird, um das Bauteil 12 auf der Montageebene anzudrücken, wodurch sich zudem ein guter Kontakt zum Abführen der Verlustwärme ergibt.

Zwischen zwei Halteleisten 27 kann an gewünschter Position in Querrichtung der Montageplatte 10 mindestens eine Brücke 28 angeordnet werden, wobei diese mittels der Schlitze 28.2 in Querrichtung entlang der Halteleisten 27 verschiebbar ist. Der mit den Bohrungen 28.1 versehene Schenkel der Brücke 28 ist dabei von der Montageebene weiter beabstandet als die Abmessung des betreffenden Fußteils 12.1 des Bauteils 12 in Normalenrichtung der Montageebene, so dass der Fußteil 12.1 unter die Brücke 28 schiebbar und über die Bohrungen 28.1 durch Eindrehen von Klemmschrauben festlegbar ist. Als Klemmschrauben 34 können dabei z.B. Gewindestifte dienen.

Zum Festlegen des Bauteils 12 auf der Montageplatte 10 bestehen dabei verschiedene Möglichkeiten, nämlich z.B. Einklemmen des Fußteils 12.1 auf einer Seite mit mindestens einem Nuteinsatz 26 unter dessen Befestigungsabschnitt 26.4 auf der einen Seite und ein Festklemmen mittels einer Brücke 28 auf der anderen Seite. Mit mehreren Halteleisten 27 und Brücken 28 und jeweils mit mindestes einem Nuteinsatz 26 lassen sich Bauteile 12 unterschiedlicher Abmessungen oder an unterschiedlichen Positionen in x-/y-Richtung auf der Montageplatte 10 anbringen, so dass die Bauteile an geeigneten freien Stellen z.B. innerhalb eines die Montageplatte 10 aufnehmenden Gehäuses auf einfache Weise positionierbar sind. Bei der Festlegung ergibt der winkelförmige Querschnitt der Halteleiste 27 und der Brücke 28 eine erhöhte Stabilität. Eine ähnliche Stabilitätswirkung kann auch mit einem T-förmigen Querschnitt oder mindestens einer Versteifungsrippe erzielt werden.

## Patentansprüche

1. Montageplatte (10) für elektronische Bauteile (12) mit in einem Plattenkörper (14) integrierten Kühlleitungen (16, 18) zur Durchströmung mit einem Kühlmedium, wobei am Plattenkörper (14) eine Befestigungseinrichtung für die Montage der elektronischen Bauteile angeordnet ist, wobei die Befestigungseinrichtung ein ein Befestigungsgewinde (25.3, 26.5) aufweisendes Haltestück (25, 26) und zumindest eine hinterschnitten ausgebildete, sich in Erstreckungsrichtung (A) der Montageplatte (10) geradlinig erstreckende erste Nut (20) aufweist, in die das mindestens eine als Nuteinsatz (26) ausgebildete Haltestück zum Festlegen des Bauteils (12) mit einem Fußabschnitt (26.1) einführbar ist,
**dadurch gekennzeichnet,**
**dass** der Nuteinsatz (26) einen aus der Nut (20, 22, 24) vorstehenden Kopfabschnitt (26.2) aufweist,
**dass** der Kopfabschnitt (26.2) einen im eingesetzten Zustand des Nuteinsatzes (26) von der Montageebene der Montageplatte (10) beabstandeten Befestigungsabschnitt (26.4) aufweist, der über einem darunter anzuordnenden Fußteil (12.1) des festzulegenden Bauteils (12) positionierbar ist, wobei der Abstand des Befestigungsabschnittes (26.4) größer ist als die Stärke des Fußteils (12.1) in Normalenrichtung zu der Montageebene, und
**dass** in dem Befestigungsabschnitt (26.4) mindestens eine Gewindebohrung (26.5) vorhanden ist, in die zum Festlegen des Bauteils (12) eine mit dem Fußteil (12.1) zusammenwirkende Klemmschraube (34) eindrehbar ist.

2. Montageplatte nach Anspruch 1,
**dadurch gekennzeichnet,**
**dass** die Befestigungseinrichtung zumindest eine gleichartig zur ersten Nut (20) ausgebildete und sich parallel zur ersten Nut (20) erstreckende zweite Nut (22) oder Rippe aufweist, deren Abstand (B) zur ersten Nut (20) im Wesentlichen durch die senkrecht zur ersten und zweiten Nut (20, 22) oder Rippe verlaufende Erstreckungslänge (B) des zu montierenden elektronischen Bauteils (12) bestimmt ist.

3. Montageplatte nach Anspruch 2,
**dadurch gekennzeichnet,**
**dass** die Befestigungseinrichtung zumindest noch eine gleichartig zur ersten Nut (20) und zur zweiten Nut (22) oder Rippe ausgebildete und sich parallel zur zweiten Nut (22) oder Rippe erstreckende weitere Nut (24) oder Rippe aufweist, die sich an der von dem zu montierenden elektronischen Bauteil abgewandten Seite (26) der zweiten Nut oder Rippe in einem Abstand (C) zu dieser erstreckt, der kleiner als der Abstand (B) zwischen der ersten Nut (20) und der zweiten Nut (22) oder Rippe ist.

4. Montageplatte nach einem der vorhergehenden Ansprüche,
**dadurch gekennzeichnet,**
**dass** zu montierende elektronische Bauteile (12), die Schraublöcher aufweisen, durch Schrauben (28, 34) direkt an den in die Nuten (20, 22, 24) oder Rippen eingeführten Haltestücken (25, 26) befestigbar sind oder mittels leistenartiger Halteelemente (27, 28) festlegbar sind, die mittelbar oder unmittelbar an den Haltestücken (25, 26) angebracht sind.

5. Montageplatte nach einem der vorhergehenden Ansprüche,
**dadurch gekennzeichnet,**
**dass** die erste Nut (20), die zweite Nut (22) und/oder die noch weitere Nut (24) mit dem Plattenkörper einstückig ausgebildet sind.

6. Montageplatte nach einem der vorhergehenden Ansprüche,
**dadurch gekennzeichnet,**
**dass** mindestens ein Haltestück als Nutstein (25) mit einem in eine der Nuten (20, 22, 24) einschiebbaren Fußabschnitt (25.1) und einem aus der Nut (20, 22, 24) vorstehenden Kopfabschnitt (25.2) ausgebildet ist und
**dass** in dem Kopfabschnitt (25.2) in Normalenrichtung zur Montageebene eine Gewindebohrung (25.3) angeordnet ist, an der ein Haltemittel für das Bauteil (12) festschraubbar ist.

7. Montageplatte nach einem der vorhergehenden Ansprüche,
**dadurch gekennzeichnet,**
**dass** die Befestigungseinrichtung mindestens eine Halteleiste (27) aufweist, die quer zu den Nuten (20, 22, 24) anordenbar und so bemessen ist, dass sie den Abstand zwischen zwei Nuten (20, 22; 20, 24) überspannt und mit ihren beiderseitigen Endabschnitten an in die betreffenden Nuten (20, 22, 24) eingeschobenen Nutsteinen (25) und/oder Nuteinsätzen (26) in Gewindebohrungen (25.3, 26.3) festlegbar ist.

8. Montageplatte nach Anspruch 7,
**dadurch gekennzeichnet,**
**dass** mindestens eine leistenartige Brücke (28) vorgesehen ist, die zwischen zwei beidseitig eines Bauteils (12) parallel zueinander angeordneten Halteleisten (27) verschiebbar mit Abstand zu der Montageebene einbringbar ist und Bohrungen (28.1) aufweist, über die das Bauteil (12) an seinem Fuß (12.1) mittels mindestens einer Klemmschraube festlegbar ist.

9. Montageplatte nach Anspruch 8,
**dadurch gekennzeichnet,**
**dass** die Brücke (28) an ihren beiden Endabschnitten zu den Halteleisten (27) hin offene Schlitze (28.2) aufweist, mit denen sie an den Halteleisten (27) verschiebbar gehalten ist.

10. Montageplatte nach einem der Ansprüche 7 bis 9,
**dadurch gekennzeichnet,**
**dass** die mindestens eine Halteleiste (27) und/oder Brücke (28) mit einer Reihe von Gewindebohrungen (27.1, 28.1) oder Befestigungsdurchbrüchen versehen ist.

11. Montageplatte nach einem der Ansprüchen 7 bis 10,
**dadurch gekennzeichnet,**
**dass** die Halteleiste (27) und/oder die Brücke (28) im Querschnitt winkelförmig ausgebildet oder mit mindestens einer Verstärkungsrippe versehen ist.

## Claims

1. Mounting plate (10) for electronic components (12), said plate having cooling conduits (16, 18), incorporated in a plate body (14), for coolant to flow therethrough, a securing means for the mounting of the electronic components being disposed on the plate body (14), the securing means having a retaining piece (25, 26), which includes a securing thread (25.3, 26.5), and at least one first groove (20), which has an undercut configuration and extends rectilinearly in the direction of extension (A) of the mounting plate (10), into which groove the at least one retaining piece, in the form of groove insert (26) for the securement of the component (12), can be inserted with a bottom portion (26.1), **characterised in that** the groove insert (26) has a top portion (26.2) protruding from the groove (20, 22, 24), **in that** the top portion (26.2) has a securing portion (26.4), which is spaced from the mounting plane of the mounting plate (10) in the inserted state of the groove insert (26) and can be positioned over a bottom portion (12.1), which is to be disposed therebeneath, of the component (12) to be secured, the spacing of the securing portion (26.4) being greater than the thickness of the bottom portion (12.1) in the direction perpendicular to the mounting plane, and **in that**, in the securing portion (26.4), there is at least one threaded bore (26.5) into which a clamping screw (34), which co-operates with the bottom portion (2.1), can be screwed for the securement of the component (12).

2. Mounting plate according to claim 1, **characterised in that** the securing means has at least one second groove (22) or rib, which is configured identically to the first groove (20) and extends parallel to the first groove (20), the spacing (B) of which second groove from the first groove (20) is determined substantially by the length of extension (B), which extends perpendicular to the first groove and second groove (20, 22) or rib, of the electronic component (12) to be mounted.

3. Mounting plate according to claim 2, **characterised in that** the securing means has at least one other additional groove (24) or rib, which is configured identically to the first groove (20) and to the second groove (22) or rib and extends parallel to the second groove (22) or rib, which additional groove or rib extends, on the side (26) of the second groove or rib which is remote from the electronic component to be mounted, at a spacing (C) from said second groove or rib which is smaller than the spacing (B) between the first groove (20) and the second groove (22) or rib.

4. Mounting plate according to one of the preceding claims, **characterised in that** electronic components (12) which are to be mounted and have screw holes, can be secured by screws (28, 34) directly onto the retaining pieces (25, 26) introduced into the grooves (20, 22, 24) or ribs, or can be secured by means of bar-like retaining members (27, 28) which are fitted indirectly or directly onto the retaining pieces (25, 26).

5. Mounting plate according to one of the preceding claims, **characterised in that** the first groove (20), the second groove (22) and/or the other additional groove (24) are configured integrally with the plate body.

6. Mounting plate according to one of the preceding claims, **characterised in that** at least one retaining piece is configured as groove block (25), having a bottom portion (25.1), which is insertable into one of the grooves (20, 22, 24), and a top portion (25.2) protruding from the groove (20, 22, 24), and **in that**, in the top portion (25.2), in the direction perpendicular to the mounting plane, a threaded bore (25.3) is disposed, on which a retaining means for the component (12) can be securedly screwed.

7. Mounting plate according to one of the preceding claims, **characterised in that** the securing means has at least one retaining bar (27), which can be disposed transversely relative to the grooves (20, 22, 24) and is so dimensioned that it bridges the spacing between two grooves (20, 22; 20, 24), and can be secured in threaded bores (25.3, 26.3), with its bilateral end portions, on groove blocks (25) and/or groove inserts (26) which are inserted into the pertinent grooves (20, 22, 24).

8. Mounting plate according to claim 7, **characterised in that** at least one bar-like bridge (28) is provided, which can be displaceably introduced, at a spacing from the mounting plane, between two retaining bars (27) disposed parallel to each other on both sides of a component (12), and which has bores (28.1), via which the component (12) can be secured at its bottom (12.1) by means of at least one clamping screw.

9. Mounting plate according to claim 8, **characterised in that** the bridge (28) has, in its two end portions, slots (28.2) which are open towards the retaining bars (27), and with which slots it is retained in a displaceable manner on the retaining bars (27).

10. Mounting plate according to one of claims 7 to 9, **characterised in that** the at least one retaining bar (27) and/or bridge (28) is provided with a row of threaded bores (27.1, 28.1) or securing apertures.

11. Mounting plate according to one of claims 7 to 10, **characterised in that** the retaining bar (27) and/or the bridge (28) has an angular cross-sectional configuration or is provided with at least one reinforcing rib.

## Revendications

1. Plaque de montage (10) pour composants électroniques (12) avec des conduits de refroidissement (16, 18) intégrés dans un corps de plaque (14) pour le passage d'un agent de refroidissement, un dispositif de fixation pour le montage des composants électroniques étant disposé sur le corps de plaque (14), le dispositif de fixation présentant une pièce de maintien (25, 26) présentant un filetage de fixation (25.3, 26.5) et au moins une première rainure (20) réalisée en contre-dépouille, s'étendant en ligne droite dans la direction d'extension (A) de la plaque de montage (10), dans laquelle ladite au moins une pièce de maintien réalisée sous forme d'insert de rainure (26) peut être introduite pour la fixation du composant (12) par une section de pied (26.1),
**caractérisée en ce**
**que** l'insert de rainure (26) présente une section de tête (26.2) dépassant de la rainure (20, 22, 24),
**que** la section de tête (26.2) présente une section de fixation (26.4) distante du plan de montage de la plaque de montage (10) à l'état inséré de l'insert de rainure (26), qui peut être positionnée au-dessus d'une partie de pied (12.1) du composant (12) à fixer à placer en dessous, la distance de la section de fixation (26.4) étant plus grande que l'épaisseur de la partie de pied (12.1) dans la direction normale au plan de montage, et
**qu'**il existe dans la section de fixation (26.4) au moins un trou fileté (26.5) dans lequel une vis de serrage (34) coopérant avec la partie de pied (12.1) peut être vissée pour fixer le composant (12).

2. Plaque de montage selon la revendication 1,
**caractérisée en ce**
**que** le dispositif de fixation présente au moins une deuxième rainure (22) ou nervure réalisée de manière analogue à la première rainure (20) et s'étendant parallèlement à la première rainure (20), dont la distance (B) à la première rainure (20) est essentiellement déterminée par la longueur d'extension (B), s'étendant perpendiculairement à la première et à la deuxième rainure (20, 22) ou nervure, du composant électronique (12) à monter.

3. Plaque de montage selon la revendication 2,
**caractérisée en ce**
**que** le dispositif de fixation présente encore au moins une autre rainure (24) ou nervure réalisée de manière analogue à la première rainure (20) ou à la deuxième rainure (22) ou nervure et s'étendant parallèlement à la deuxième rainure (22) ou nervure, qui s'étend du côté de la deuxième rainure ou nervure opposé (26) au composant électronique à monter à une distance (C) qui est plus petite que la distance (B) entre la première rainure (20) et la deuxième rainure (22) ou nervure.

4. Plaque de montage selon l'une des revendications précédentes,
**caractérisée en ce**
**que** des composants électroniques (12) à monter qui présentent des trous de vis peuvent être fixés directement par des vis (28, 34) aux pièces de maintien (25, 26) introduites dans les rainures (20, 22, 24) ou nervures, ou fixés au moyen d'éléments de maintien (27, 28) en forme de barre qui sont montés indirectement ou directement sur les pièces de maintien (25, 26).

5. Plaque de montage selon l'une des revendications précédentes,
**caractérisée en ce**
**que** la première rainure (20), la deuxième rainure (22) et/ou l'autre rainure (24) forment une seule pièce avec le corps de plaque.

6. Plaque de montage selon l'une des revendications précédentes,
**caractérisée en ce**
**qu'**au moins une pièce de maintien est réalisée sous forme de coulisseau (25) avec une section de pied (25.1) pouvant être insérée dans une des rainures (20, 22, 24) et une section de tête (25.2) dépassant de la rainure (20, 22, 24) et
**qu'**un trou fileté (25.3) est disposé dans la section de tête (25.2) dans la direction normale au plan de montage, dans lequel un moyen de fixation pour le composant (12) peut être vissé.

7. Plaque de montage selon l'une des revendications précédentes,
**caractérisée en ce**
**que** le dispositif de fixation présente au moins une barre de maintien (27) qui peut être disposée transversalement aux rainures (20, 22, 24) et qui est dimensionnée de façon à couvrir la distance entre deux rainures (20, 22 ; 20, 24) et à pouvoir être fixée par ses sections d'extrémité des deux côtés à des coulisseaux (25) et/ou inserts de rainure (26) insérés dans les rainures concernées (20, 22, 24) dans des trous filetés (25.3, 26.3).

8. Plaque de montage selon la revendication 7,
**caractérisée en ce**
**qu'**il est prévu au moins un pont (28) en forme de barre qui peut être monté avec possibilité de coulissement à distance du plan de montage entre deux barres de maintien (27) disposées parallèlement l'une à l'autre des deux côtés d'un composant (12) et qui présente des trous (28.1) par lesquels le composant (12) peut être fixé par son pied (12.1) au moyen d'au moins une vis de serrage.

9. Plaque de montage selon la revendication 8,
**caractérisée en ce**
**que** le pont (28) présente à ses deux sections d'extrémité des fentes (28.2) ouvertes vers les barres de maintien (27) avec lesquelles il est maintenu avec possibilité de coulissement sur les barres de maintien (27).

10. Plaque de montage selon l'une des revendications 7 à 9,
**caractérisée en ce**
**que** ladite au moins une barre de maintien (27) et/ou ledit au moins un pont (28) sont munis d'une série de trous filetés (27.1, 28.1) ou d'ouvertures de fixation.

11. Plaque de montage selon l'une des revendications 7 à 10,
**caractérisée en ce**
**que** la barre de maintien (27) et/ou le pont (28) sont angulaires en section ou munis d'au moins une nervure de renfort.
